# EUROPÄISCHE PATENTSCHRIFT

(11) **EP 4 288 379 B1**
(45) Veröffentlichungstag und Bekanntmachung des Hinweises auf die Patenterteilung: **25.12.2024**
(21) Anmeldenummer: 22707643.7
(22) Anmeldetag: 07.02.2022
(51) Int. Cl.: B81C 1/00

(54) **MEMS-PACKAGE UND VERFAHREN ZUM VERKAPSELN EINER MEMS-STRUKTUR**
MEMS PACKAGE AND METHOD FOR ENCAPSULATING A MEMS STRUCTURE
BOÎTIER MEMS ET PROCÉDÉ D'ENCAPSULATION D'UNE STRUCTURE MEMS

(30) Priorität: 08.02.2021 DE 102021201151
(43) Veröffentlichungstag der Anmeldung: 13.12.2023
(73) Patentinhaber: Fraunhofer-Gesellschaft zur Förderung der angewandten Forschung e.V., 80686 München (DE)
(72) Erfinder: SENGER, Frank, 25524 Itzehoe (DE); GU-STOPPEL, Shanshan, 25524 Itzehoe (DE); YARAR, Erdem, 25524 Itzehoe (DE); WILLE, Gunnar, 25524 Itzehoe (DE)
(74) Vertreter: König, Andreas Rudolf
(86) Internationale Anmeldenummer: PCT/EP2022/052854
(87) Internationale Veröffentlichungsnummer: WO 2022/167645

(56) Entgegenhaltungen:
- US-A1- 2020 385 264
- ULRICH HOFMANN ET AL: "Resonant biaxial 7-mm MEMS mirror for omnidirectional scanning", JOURNAL OF MICRO/NANOLITHOGRAPHY, MEMS, AND MOEMS, vol. 13, no. 1, 2 December 2013 (2013-12-02), US, pages 011103, XP055501423, ISSN: 1932-5150, DOI: 10.1117/1.JMM.13.1.011103
- SENGER F ET AL: "A bi-axial vacuum-packaged piezoelectric MEMS mirror for smart headlights", SPIE PROCEEDINGS; [PROCEEDINGS OF SPIE ISSN 0277-786X], SPIE, US, vol. 11293, 28 February 2020 (2020-02-28), pages 1129305 - 1129305, XP060130395, ISBN: 978-1-5106-3673-6, DOI: 10.1117/12.2542802

## Beschreibung

Die vorliegende Erfindung bezieht sich auf ein Verfahren zum Verkapseln einer MEMS-Struktur, wie etwa mit einem beweglichen Element, etwa bei quasi-statischen MEMS-Komponenten wie MEMS-Vektor-Scannern. Die vorliegende Erfindung bezieht sich ferner auf ein MEMS-Package. Die vorliegende Erfindung bezieht sich ferner auf ein Anordnen eines Waferstapels für hermetische Verkapselung mit definiertem Innendruck für eine quasi-statische MEMS-Komponente.

MEMS-Vektor-Scanner werden mit einer hybriden Montage, wie z. B. unter Verwendung eines Keramikgehäuses, gekapselt.

MEMS-Vektor-Scanner haben zum Zweck hoher mechanischer Effizienz komplexe Strukturen, z. B. eine 3D-Aufbauweise, wo sich die Aktuatoren und die Spiegelplatte auf unterschiedlichen Ebenen befinden. Diese 3D-Aufbauweise wird häufig genutzt, ist aber für eine Verkapselung hinderlich und erschwert diese.

MEMS-Vektor-Scanner werden zum Einstellen ihres Verhaltens in einer hybriden Montage gekapselt und hermetisch versiegelt. Die hermetische Verkapselung der Vektor-Scanner mit einer 3D-Aufbauweise, wo die Aktuatoren und Spiegelplatten auf unterschiedlichen Höhen/Ebenen angeordnet sind, ermöglicht zwar die Schutzwirkung für MEMS-Komponenten, dabei erleidet die MEMS-Komponente trotzdem Einflüsse aufgrund äußerer Störeinflüsse, wie etwa Partikel. Auch ein Ausgasen wegen der unterschiedlichen Herstellungsumgebungen und -verfahren und der erforderliche Transport zwischen den Herstellungsumgebungen ist hinderlich. MEMS-Komponenten werden in der Regel in einem Reinraum hergestellt und die spätere hybride Montage wird im Laborbereich mittels eines Klebers realisiert.

Wünschenswert wäre ein Verfahren zum Herstellen eines MEMS-Packages bzw. zum Verkapseln einer MEMS-Struktur und ein MEMS-Package, das die vorgenannten Nachteile vermeidet und trotzdem effizient und mit geringen Fehlern herstellbar ist.

Die Aufgabe der vorliegenden Erfindung besteht deshalb darin, ein Verfahren zum Verkapseln einer MEMS-Struktur und ein MEMS-Package zu schaffen, die eine effiziente Herstellung mit geringen Fehlern ermöglichen.

Diese Aufgabe wird durch den Gegenstand der unabhängigen Patentansprüche gelöst. SENGER F ET AL: "A bi-axial vacuum-packaged piezoelectric MEMS mirror for smart headlights", SPIE PROCEEDINGS; SPIE, US, Bd. 11293, 28. Februar 2020 (2020-02-28), Seiten 1129305-1129305, DOI: 10.1117/12.2542802, ISBN: 978-1-5106-3673-6 offenbart die Herstellung eines gehäusten Mikrospiegels, bei dem ein Bodenwafer, ein funktionaler Wafer mit der MEMS-Struktur, ein rahmenförmig strukturierter Abstandswafer und ein Glaswafer zu einer Stapelstruktur verbunden werden.

Ein Kerngedanke der vorliegenden Erfindung besteht darin, für das Verkapseln einer MEMS-Struktur eine Abstandsstruktur zwischen einem Teil einer MEMS-Struktur und einem vermittels eines Glaswafers implementierten Deckels vorzusehen. Dies ermöglicht geringe Prozessierungsanforderungen an dem Glaswafer, eine einfache Positionierung der Abstandsstruktur bezüglich der MEMS-Struktur und weiterhin eine Fertigung auf Wafer-Level, so dass auf effiziente Weise eine Kapselung mit einer geringen Fehleranfälligkeit ermöglicht ist.

Gemäß einer Variante der Erfindung umfasst ein Verfahren zum Verkapseln einer MEMS-Struktur in einer Stapelstruktur ein Bereitstellen einer funktionalen Waferstruktur, die zumindest teilweise eine MEMS-Struktur umfasst. Zum Verkapseln der MEMS-Struktur in einer Stapelstruktur erfolgt ferner ein Anordnen der funktionalen Waferstruktur und eines Glaswafers in der Stapelstruktur und entlang einer Stapelrichtung zueinander. Das Verfahren wird so ausgeführt, dass eine Kavität, in welcher zumindest ein Teil der MEMS-Struktur angeordnet ist, an einer Seite entlang der Stapelrichtung mit dem Glaswafer verschlossen ist und, so dass eine Abstandsstruktur zwischen dem Teil der MEMS-Struktur und dem Glaswafer in der Stapelstruktur angeordnet wird, um einen Abstand zwischen dem Teil der MEMS-Struktur und dem Glaswafer entlang der Stapelrichtung bereitzustellen, so dass die Abstandsstruktur einen Teil der Kavität umschließt. Erfindungsgemäß wird dabei die Abstandsstruktur aus der funktionalen Waferstruktur mittels lokal selektiver Entfernung der funktionalen Waferstruktur gebildet.

Gemäß einer anderen Variante der Erfindung umfasst ein Verfahren zum Verkapseln von MEMS-Strukturen in einer Stapelstruktur ein Bereitstellen einer Stapelstruktur mit einer Vielzahl von MEMS-Bereichen, so dass jeder MEMS-Bereich eine MEMS-Struktur aufweist, die zumindest teilweise in einer MEMS-Kavität angeordnet ist, so dass die Stapelstruktur eine Abstandsstruktur aufweist, die jede der Kavitäten der MEMS-Bereiche zumindest teilweise umschließt und einen Abstand zu der MEMS-Struktur bereitstellt. Das Verfahren umfasst ferner ein Anordnen eines Glaswafers an der Abstandsstruktur durch Ausführen eines Wafer-Bonding-Prozesses, so dass vermittels des Glaswafers die Kavitäten an einer Seite der Abstandsstruktur hermetisch dicht verschlossen werden. Erfindungsgemäß wird auch hier die Abstandsstruktur aus der funktionalen Waferstruktur mittels lokal selektiver Entfernung der funktionalen Waferstruktur gebildet. Vorteilhaft daran ist, dass durch Einstellen des Abstands durch die Abstandsstruktur ein komplexer Aufbau des Glaswafers entfallen kann und dieser einfach, effizient und mit geringen Fehlern bereits auf Wafer-Level zur Verkapselung der MEMS-Struktur genutzt werden kann.

Ein erfindungsgemäßes MEMS-Package umfasst eine Stapelstruktur, die mehrere entlang einer Stapelrichtung gestapelte Schichten umfasst, und die eine funktionale Waferstruktur aufweist, die eine MEMS-Struktur umfasst. Die MEMS-Struktur ist zumindest teilweise in einer Kavität angeordnet, wobei die Kavität einen Teil der Stapelstruktur bildet. Die Kavität ist entlang der Stapelrichtung an einer Seite von einer Glasschicht begrenzt, die durch eine Abstandsstruktur entlang der Stapelrichtung von der MEMS-Struktur beabstandet ist. Erfindungsgemäß wird auch hier die Abstandsstruktur aus der funktionalen Waferstruktur mittels lokal selektiver Entfernung der funktionalen Waferstruktur gebildet.

Weitere vorteilhafte Ausführungsbeispiele sind der Gegenstand abhängiger Patentansprüche.

Besonders bevorzugte Ausführungsbeispiele werden nachfolgend Bezug nehmend auf die beiliegenden Zeichnungen erläutert. Es zeigen:
- Fig. 1: ein schematisches Ablaufdiagramm eines Verfahrens gemäß einem Ausführungsbeispiel;
- Fig. 2: ein schematisches Ablaufdiagramm eines Verfahrens gemäß einem Ausführungsbeispiel, das beispielsweise zumindest einen Teil eines Schritts des Verfahrens aus Fig. 1 implementieren kann;
- Fig. 3: ein schematisches Ablaufdiagramm eines weiteren Verfahrens gemäß einem Ausführungsbeispiel, das alternativ oder zusätzlich zumindest einen Teil eines Schritts des Verfahrens aus Fig. 1 ausführen kann und beispielsweise alternativ oder zusätzlich zu dem Verfahren aus Fig. 2 ausgeführt werden kann;
- Fig. 4: eine schematische Seitenschnittansicht eines beispielhaften funktionalen Wafers im Zusammenhang mit hierin beschriebenen Ausführungsbeispielen;
- Fig. 5: eine schematische Seitenschnittansicht einer weiteren funktionalen Waferstruktur gemäß einem Ausführungsbeispiel;
- Fig. 6: eine schematische Seitenschnittansicht einer Stapelstruktur, die durch Aneinanderfügen der funktionalen Waferstrukturen aus Fig. 4 und Fig. 5 erhalten werden kann;
- Fig. 7: eine schematische Seitenschnittansicht einer Waferstruktur gemäß einem Ausführungsbeispiel die bspw. als Boden- oder Deckelwafer eingesetzt werden kann;
- Fig. 8: eine schematische Seitenschnittansicht einer Stapelstruktur gemäß einem Ausführungsbeispiel, die aus einer bearbeiteten Version der Stapelstruktur aus Fig. 6 und der Waferstruktur aus Fig. 7 erhalten werden kann;
- Fig. 9: eine schematische Seitenschnittansicht einer Stapelstruktur gemäß einem Ausführungsbeispiel, die durch Kombination der Stapelstruktur aus Fig. 8 mit einem Glaswafer erhalten werden kann; und
- Fig. 10: eine schematische Seitenschnittansicht einer Stapelstruktur gemäß einem Ausführungsbeispiel, die durch weitere Bearbeitung der Stapelstruktur aus Fig. 9 erhalten werden kann.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele werden im Zusammenhang mit einer Vielzahl von Details beschrieben. Ausführungsbeispiele können jedoch auch ohne diese detaillierten Merkmale implementiert werden. Des Weiteren werden Ausführungsbeispiele der Verständlichkeit wegen unter Verwendung von Blockschaltbildern als Ersatz einer Detaildarstellung beschrieben. Ferner können Details und/oder Merkmale einzelner Ausführungsbeispiele ohne Weiteres mit einander kombiniert werden, solange es nicht explizit gegenteilig beschrieben ist.

Nachfolgende Ausführungsbeispiele beziehen sich auf eine Verkapselung einer MEMS-Struktur. Als beispielhafte MEMS-Struktur wird dabei ein MEMS-Vektor-Scanner betrachtet, also ein mikroelektromechanisches System (MEMS), das eine optisch reflektierende Fläche aufweist, welche durch Verwenden einer Aktuatorik ausgelenkt wird. Eine optische Quelle hierzu kann Teil des MEMS sein, dies ist jedoch nicht erforderlich für die Betrachtung der vorliegenden Erfindung. Eine beispielhafte Lichtquelle ist beispielsweise ein Laser oder eine andere Quelle elektromagnetischer Strahlung im sichtbaren oder nichtsichtbaren Wellenlängenbereich. Obwohl Vektor-Scanner in der Regel nicht-resonant betrieben werden, ist die vorliegende Erfindung nicht hierauf beschränkt. Vielmehr können auch andere, beispielsweise resonant betriebene MEMS mit den hierin beschriebenen Verfahren verkapselt werden und/oder es können auch MEMS verkapselt werden, die andere bewegliche Elemente aufweisen oder möglicherweise keine beweglichen Elemente. Eine Verkapselung von MEMS-Strukturen kann auch für andere Bereiche relevant sein, wo beispielsweise eine Referenzatmosphäre gegenüber einem äußeren Einfluss gekapselt werden soll, wobei hier beispielsweise optische Bereiche oder Bereiche zur Bemessung einer Veränderung in der Referenz-Atmosphäre in Betracht kommen.

Nachfolgende Ausführungsbeispiele beziehen sich auf eine Verkapselung einer MEMS-Struktur. Diese kann einschichtig oder mehrschichtig aufgebaut sein und Halbleitermaterialien, wie beispielsweise siliziumbasiert, Kaliumarsenit oder dergleichen aufweisen. Ausführungsbeispiele sind dabei jedoch nicht auf anorganische Halbleiter beschränkt, sondern können ohne weiteres auch auf organische, etwa metallorganische Halbleiter angewendet werden.

MEMS-Strukturen können dabei Halbleitermaterialien aufweisen, die unter Einfluss weiterer Prozessierungsschritte elektrisch isolierende Eigenschaften aufweisen, beispielsweise Siliziumoxid oder Siliziumnitrid, die bereichsweise elektrisch leitfähig gebildet sind, etwa durch eine Dotierung, die durch Anordnen zusätzlicher Schichten funktionalisiert sind, wobei ohne weiteres auch eine lokale selektive Entfernung von Schichten in Betracht kommt.

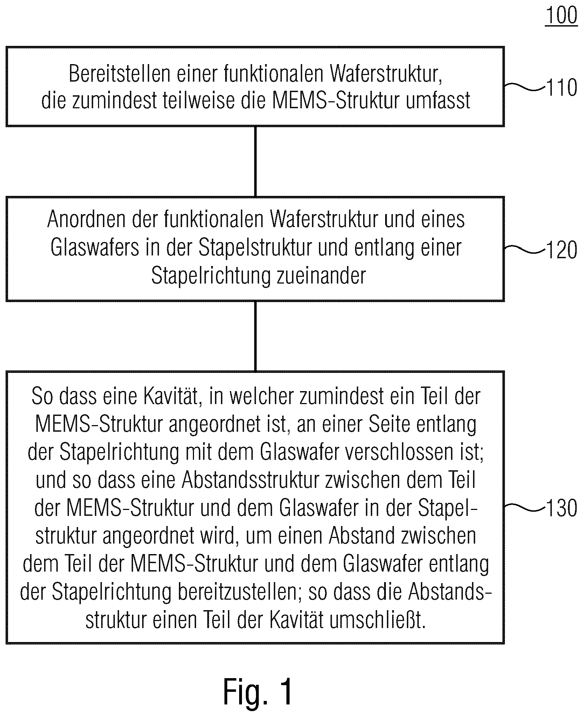

Fig. 1 zeigt ein schematisches Ablaufdiagramm eines Verfahrens 100 gemäß einem Ausführungsbeispiel. Das Verfahren 100 kann zum Verkapseln einer MEMS-Struktur in einer Stapelstruktur verwendet werden, das bedeutet, die MEMS-Struktur ist in der Stapelstruktur angeordnet. Das Verfahren 100 umfasst einen Schritt 110, in dem ein Bereitstellen einer funktionalen Waferstruktur erfolgt, die zumindest teilweise die MEMS-Struktur umfasst. Als funktional kann an dieser Stelle eine elektrische Funktion, das bedeutet, eine elektrische Leitfähigkeit und/oder Isolation und/oder eine mechanische Bewegung verstanden werden. Die Waferstruktur kann dabei einen oder mehrere funktionale Wafer umfassen, was später noch detailliert erläutert wird.

Ein Schritt 120 umfasst ein Anordnen der funktionalen Waferstruktur und eines Glaswafers in der Stapelstruktur und entlang einer Stapelrichtung zueinander, das bedeutet, der Glaswafer und die funktionale Waferstruktur werden gemeinsam in der Stapelstruktur angeordnet. Beispielsweise kann der Glaswafer vermittels eines Waferbondings an die Schichten der Waferstruktur bzw. einer bereits gebildeten Stapelstruktur mit der Waferstruktur gebondet werden. Das Verfahren 100 wird dabei so ausgeführt, dass eine Kavität, in welcher zumindest ein Teil der MEMS-Struktur angeordnet ist, an einer Seite entlang der Stapelrichtung mit dem Glaswafer verschlossen ist, beispielsweise hermetisch dicht, und so dass eine Abstandsstruktur zwischen dem Teil der MEMS-Struktur und dem Glaswafer in der Stapelstruktur angeordnet wird, um einen Abstand zwischen dem Teil der MEMS-Struktur und dem Glaswafer entlang der Stapelrichtung bereitzustellen, so dass die Abstandsstruktur einen Teil der Kavität umschließt. Dies ist in einem Schritt 130 dargestellt. Zumindest Teile des Schritts 130 können als separater Schritt des Verfahrens 100 ausgeführt werden oder als Teil anderer Schritte, beispielsweise des Schritts 120. Ein Ergebnis des Verfahrens 100 kann eine MEMS-Struktur sein, die zumindest an einer Seite entlang der Stapelrichtung die Abstandsstruktur aufweist, was dazwischenliegende Schichten nicht ausschließt. Die Abstandsstruktur kann einschichtig oder mehrschichtig sein und einen Teil der Struktur für den Glaswafer bereitstellen, der die Kavität umschließt.

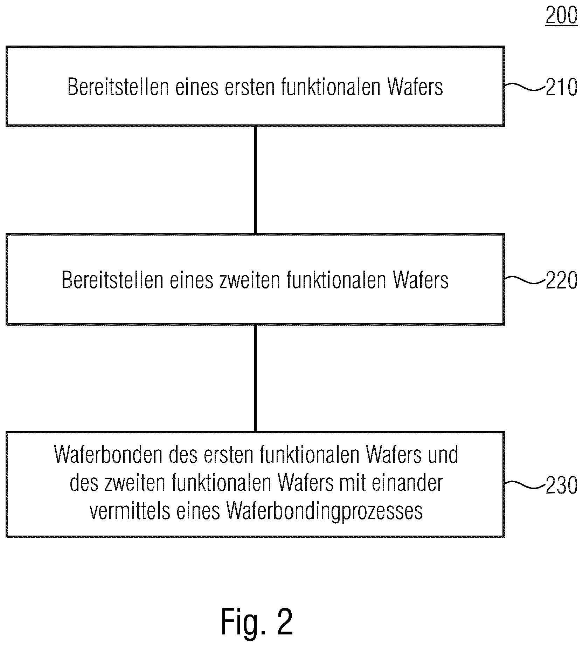

Fig. 2 zeigt ein schematisches Ablaufdiagramm eines Verfahrens 200, das beispielsweise zumindest einen Teil des Schritts 110 des Verfahrens 100 implementieren kann. Ein Schritt 210 umfasst ein Bereitstellen eines ersten funktionalen Wafers. Ein Schritt 220 umfasst ein Bereitstellen eines zweiten funktionalen Wafers. In einem Schritt 230 kann ein Waferbonden des ersten funktionalen Wafers und des zweiten funktionalen Wafers miteinander vermittels eines Waferbondingprozesses ausgeführt werden.

Das Verfahren 200 ist dabei eine mögliche Ausgestaltung des Schritts 110. Vermittels des Verfahrens 200 können mehrschichtige funktionale Waferstrukturen hergestellt oder bereitgestellt werden. Alternativ oder zusätzlich kann der Schritt 110 auch ein Herausätzen aus einer Gesamtschichtfolge nacheinander aufgewachsener Schichten oder dergleichen aufweisen. Alternativ oder zusätzlich kann der Schritt 110 auch durch Zuliefern der funktionalen Waferstruktur ausgeführt werden.

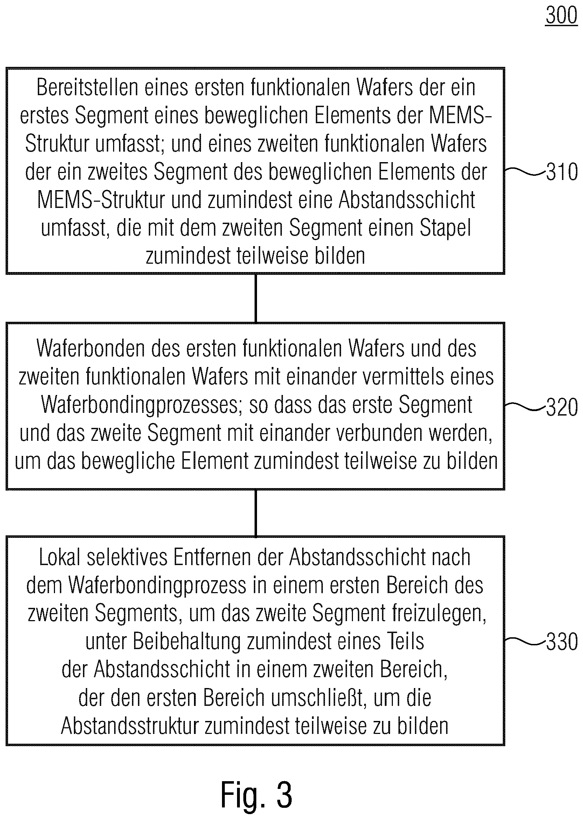

Fig. 3 zeigt ein schematisches Ablaufdiagramm eines Verfahrens 300 gemäß einem Ausführungsbeispiel, das alternativ oder zusätzlich zumindest einen Teil des Schritts 110 ausführen kann und beispielsweise alternativ oder zusätzlich zu dem Verfahren 200 ausgeführt werden kann oder dieses zumindest näher ausgestalten kann.

In einem Schritt 310 kann ein Bereitstellen eines ersten funktionalen Wafers erfolgen, der ein erstes Segment eines beweglichen Elements der MEMS-Struktur umfasst. Ferner kann ein Bereitstellen eines zweiten funktionalen Wafers erfolgen, der ein zweites Segment des beweglichen Elements der MEMS-Struktur und zumindest eine Abstandsschicht umfasst, die mit dem zweiten Segment einen Stapel zumindest teilweise bilden. Der Schritt 310 kann beispielsweise die Schritte 210 und 220 bereitstellen.

In einem Schritt 320 kann ein Waferbonden des ersten funktionalen Wafers und des zweiten funktionalen Wafers miteinander und vermittels eines Waferbondingprozesses erfolgen. Dadurch kann das erste Segment und das zweite Segment miteinander verbunden werden, um das bewegliche Element der MEMS-Struktur zumindest teilweise zu bilden. Der Schritt 320 kann den Schritt 230 zumindest in Teilen bereitstellen.

In einem Schritt 330 kann ein lokal selektives Entfernen der Abstandsschicht nach dem Waferbondingprozess und in einem ersten Bereich des zweiten Segments erfolgen, um das zweite Segment freizulegen. Dabei kann das lokal selektive Entfernen so ausgeführt werden, das unter Beibehaltung zumindest eines Teils der Abstandsschicht in einem zweiten Bereich, der den ersten Bereich umschließt, die Abstandsstruktur zumindest teilweise gebildet wird. Das bedeutet, aus der Abstandsschicht kann ein Segment der beweglichen Struktur herausgelöst werden und gleichzeitig die Abstandsschicht erhalten werden, etwa wenn das Verfahren 300 ausgeführt wird.

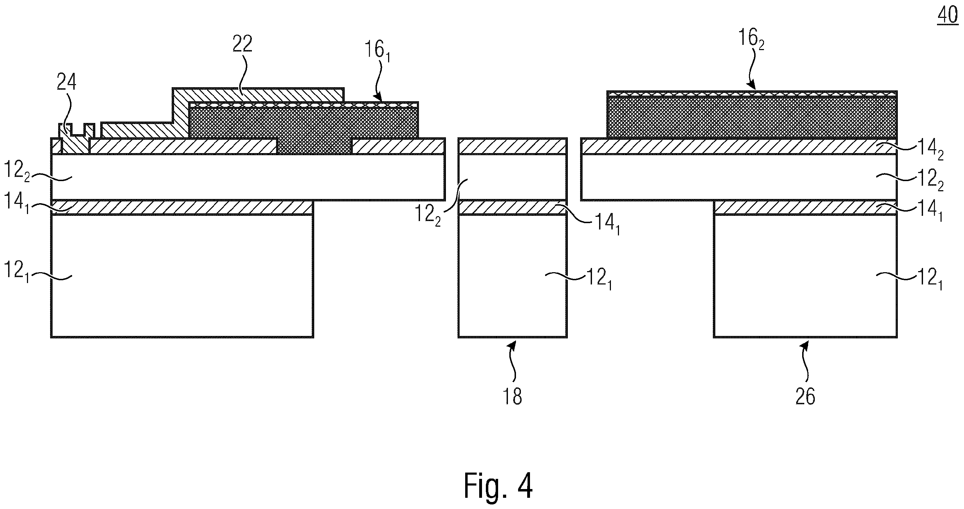

Fig. 4 zeigt eine schematische Seitenschnittansicht eines beispielhaften funktionalen Wafers 40 im Zusammenhang mit hierin beschriebenen Ausführungsbeispielen. Die Waferstruktur 40 kann eine oder mehrere Substratschichten 12₁, 12₂ und/oder weitere Substratschichten aufweisen. Zwischen Substratschichten 12₁ und 12₂ kann möglicherweise eine Zwischenschicht 14₁ angeordnet sein. Diese kann beispielsweise eine Oxidschicht und/oder eine Nitridschicht umfassen, kann eine einzige Schicht umfassen oder kann auch ein mehrschichtiges Verbundsystem aufweisen. Eine Funktion der Zwischenschicht 14, kann beispielsweise ein Verbinden der Substratschichten 12₁, 12₂ umfassen, es kann eine elektrische Leitfähigkeit oder eine elektrische Isolation bereitgestellt werden, es kann aber auch eine andere Funktion bereitgestellt werden, beispielsweise eine Implementierung einer Ätzstoppschicht oder dergleichen.

Die Waferstruktur 40 kann optional eine, zwei oder mehrere Aktuatorstrukturen 16₁ und 16₂ aufweisen, die möglicherweise ausgebildet sind, um einen auslenkbaren Bereich 18 in einem späteren MEMS auszulenken. Die Aktuatorstrukturen 16₁ und 16₂ können beispielsweise piezoelektrische Funktionsschichten umfassen, thermomechanische oder thermoelektrische Funktionsschichten umfassen, magnetoaktive Materialien aufweisen oder ein beliebiges anderes aktuatorisches Prinzip bereitstellen. Alternativ oder zusätzlich können auch sensorische Materialien am Ort der Aktuatorstrukturen 16₁ und/oder 16₂ oder an anderen Orten angeordnet sein, etwa um eine Bewegung des auslenkbaren Bereichs 18 auszuwerten. Dabei ist es möglich, aber nicht notwendig, dass der auslenkbare Bereich 18 überhaupt implementiert ist.

Für eine elektrische Kontaktierung eines aktiven oder sensorisch funktionalen Materials können ein oder mehrere elektrische Leiterstrukturen 22 angeordnet sein, die beispielsweise über eine elektrische Kontaktierung 24 elektrisch ansteuerbar sind. Das bedeutet, die elektrische Kontaktierung 24 und der elektrische Leiter 22 können in einer nicht dargestellten Schnittebene der Waferstruktur 40 elektrisch miteinander verbunden sein. Ebenso können der auslenkbare Bereich 18 und ein äußerer Bereich 24 der Waferstruktur 40 über ein oder mehrere mechanische Elemente, beispielsweise Federelemente, miteinander verbunden sein, um den auslenkbaren Bereich 18 gegenüber dem äußeren Bereich 24 aufzuhängen oder zu stützen.

Zwischen dem beispielhaft als piezoelektrische Aktuatoren gebildeten Elementen 16₁ und 16₂ einerseits und weiteren Substratschichten 12₁ und/oder 12₂ können Zwischenschichten angeordnet sein, beispielsweise eine elektrisch isolierende Zwischenschicht 14₂.

In anderen Worten zeigt Fig. 4 eine Darstellung eines ersten funktionalen Wafers, im Fall eines MEMS-Vektor-Scanners beispielsweise der Aktuator-Wafer. In Fig. 4 sind zumindest manche der funktionalen Teile des Bauteils dargestellt, etwa um die gewünschte Bewegung zu realisieren.

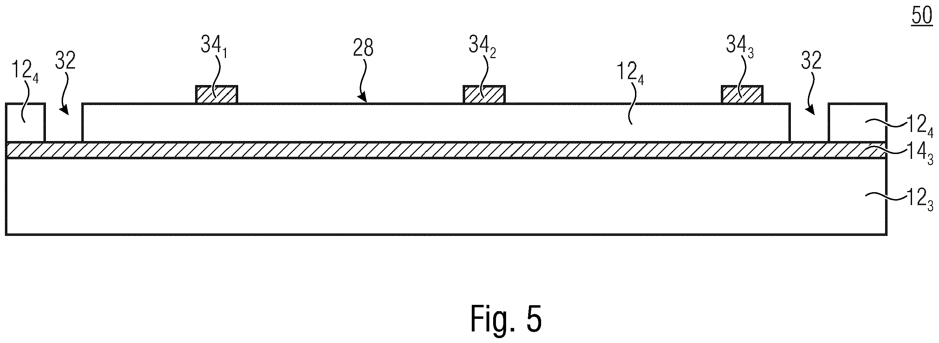

Fig. 5 zeigt eine schematische Seitenschnittansicht einer funktionalen Waferstruktur 50 gemäß einem Ausführungsbeispiel. Die funktionale Waferstruktur 50 kann eine oder mehrere Substratschichten 12s und 12₄ aufweisen, wobei eine geringere oder höhere Anzahl an Substratschichten ebenfalls möglich ist. Ebenso wie die Substratschichten 12₁ und 12₂ aus Fig. 4 können die Substratschichten 12₃, und 12₄ gleiche oder voneinander verschiedene Materialien aufweisen.

Eine oder mehrere der Substratschichten 12₃ und 12₄ kann in Teilbereiche strukturiert sein, wie es beispielhaft für die Substratschicht 12₄ dargestellt ist, die durch eine Zwischenschicht 14₃ von der Substratschicht 12₃ getrennt ist bzw. eine mechanische Verbindung zwischen diesen Schichten bereitstellt. Die Substratschicht 12₄ kann für sich genommen oder im Zusammenspiel mit weiteren Schichten, etwa der Schicht 14₃ oder einer anderen Schicht, später eine Funktion des MEMS bereitstellen, beispielsweise die Funktion einer Spiegelfläche. Im Rahmen des Ausführungsbeispiels der Herstellung oder Verkapselung eines MEMS-Vektor-Scanners kann die funktionale Waferstruktur 50 beispielsweise als Spiegelwafer verstanden werden. In anderen Worten zeigt Fig. 5 einen zweiten funktionalen Wafer, im Fall eines MEMS-Vektor-Scanners den Spiegelwafer. Je nach Art der MEMS-Komponente kann ein funktionaler Wafer, zwei funktionale Wafer oder möglicherweise auch eine höhere Anzahl, durch die hierin beschriebenen Verfahren hermetisch verkapselt werden.

Durch Bereitstellen oder Erzeugen der funktionalen Waferstruktur 40 kann beispielsweise der Schritt 110 oder 120 ausgeführt werden. Durch Herstellen, Erzeugen oder Bereitstellen der funktionalen Waferstruktur 50 kann beispielsweise der andere der Schritte 110 und 120 bzw. 210 und 220 ausgeführt werden.

Unter Bezugnahme auf das Verfahren 300 kann der Schritt 310 beispielsweise so ausgeführt werden, dass als erster funktionaler Wafer die Waferstruktur 40 und als zweiter funktionaler Wafer die Waferstruktur 50 bereitgestellt wird. Der auslenkbare Bereich 18 der funktionalen Waferstruktur 40 kann beispielsweise ein bewegliches Element der MEMS-Struktur umfassen oder bereitstellen oder zumindest einen Teil davon bilden. Ein Teil der Schicht 12₄ der funktionalen Waferstruktur 50 kann dahingegen ein zweites Segment des beweglichen Elements der MEMS-Struktur bereitstellen. Wie es noch ausgeführt werden wird, kann aus der Schicht 12₃ eine Abstandsschicht herausgebildet werden, die im späteren MEMS Verwendung finden kann.

Die Substratschicht 12₄ kann beispielsweise einen inneren Bereich 28 aufweisen, etwa indem ein oder mehrere Gräben 32 in die Schicht eingebracht werden. Alternativ oder zusätzlich können eine oder mehrere Verbindungsstellen 34₁, 34₂ und/oder 34s angeordnet sein, die im Rahmen eines späteren Verbindungsprozesses, etwa eines Waferbondingprozesses, eine mechanische Verbindung zu einer benachbarten Schicht bereitstellen können. Beispielsweise kann hierzu ein Siliziumoxid oder ein Siliziumnitridmaterial verwendet werden. Alternativ kann ein beliebiges anderes Material zum Waferbonden angeordnet werden. Es ist dabei möglich, aber nicht notwendig, dass die Verbindungsstellen 34, bis 34₃ vollständig an der funktionalen Waferstruktur 50 angeordnet werden, sie können alternativ oder zusätzlich ganz oder teilweise auch an der funktionalen Waferstruktur 40 angeordnet werden.

Das bedeutet, die funktionalen Waferstrukturen 40 und/oder 50 können auch beliebig anders implementiert werden.

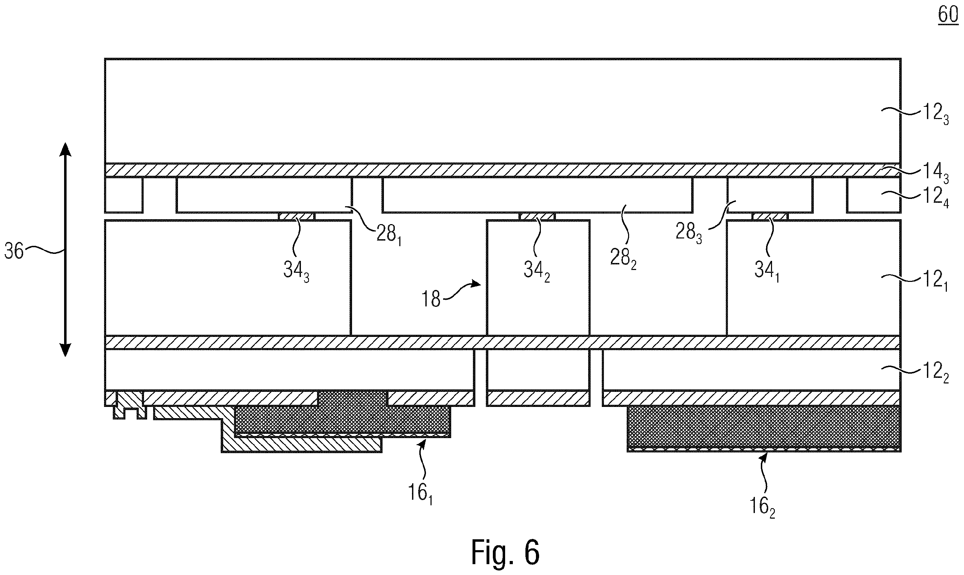

Fig. 6 zeigt eine schematische Seitenschnittansicht einer Stapelstruktur 60, die durch Aneinanderfügen der funktionalen Waferstrukturen 40 und 50 erhalten werden kann. Vermittels eines Waferbondingprozesses, beispielsweise im Rahmen des Schritts 320, des Schritts 230 und/oder des Schritts 110 insgesamt. Dadurch können die Substratschichten 12₁, 12₂, 12₃ und 12₄ gemeinsamer Teil der Stapelstruktur 60 sein und entlang einer Stapelrichtung 36 angeordnet sein.

Ferner ist der innere Bereich 28 der funktionalen Waferstruktur 50 in mehrere Teilsegmente 28₁, 28₂ und 28₃ strukturiert. Das Segment 28₂ kann gemeinsam mit dem auslenkbaren Bereich 18 später zumindest einen Teil eines auslenkbaren Spiegels bilden.

In anderen Worten kann der Spiegel-Wafer 50 im Falle eines Vektor-Scanners mit dem Aktuator-Wafer 40 zusammengebondet werden. So kann das funktionale Teil aus einem oder zwei Wafern bestehen.

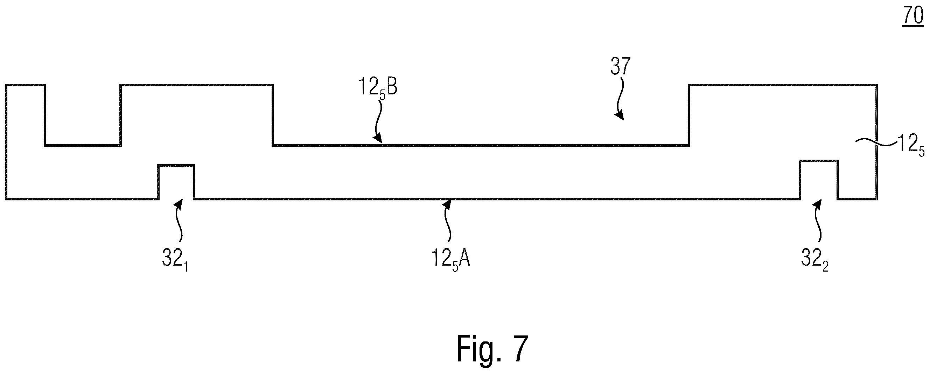

Fig. 7 zeigt eine schematische Seitenschnittansicht einer Waferstruktur 70 gemäß einem Ausführungsbeispiel. Diese umfasst beispielhaft eine einzige Substratschicht 12s, wobei alternativ auch eine höhere Anzahl von Substratschichten angeordnet sein kann, die einstückig oder miteinander vermittels Zwischenschichten verbunden sein können. Die Substratschicht 12₅ kann an einen oder beiden gegenüberliegenden Hauptseiten planar gebildet sein oder an einer oder an beiden Hauptseiten strukturiert sein. Die Waferstruktur 70 kann dabei in dem Stapel 60 angeordnet werden, um als Begrenzungswaferstruktur einen Teil der Stapelstruktur zu bilden.

So können beispielsweise an einer Hauptseite 12₅A angeordnete Gräben 32₁ und 32₃ Markierungen für ein späteres Dicing oder Vereinzeln von Wafersegmenten eingebracht sein. An einer gegenüberliegenden Hauptseite 12₅B können ebenfalls eine oder mehrere Vertiefungen oder Einsparungen angeordnet sein. Eine Aussparung 37 an der Seite 12₅B kann beispielsweise an eine Bewegung einer oder mehrerer Segmente einer späteren MEMS-Struktur angepasst sein. Die Aussparung ist dabei bevorzugt in einer einzelnen Schicht oder Halbleiterschicht eingebracht, d. h., Seitenwände der Aussparung 37 sind bevorzugt in derselben Schicht angeordnet wie eine Bodenfläche.

In anderen Worten zeigt Fig. 7 einen Bodenwafer, der genutzt werden kann, wenn eine Kavität vorgesehen ist. Der Boden der Kavität kann eine untere Grenze der hermetischen Verkapselung darstellen.

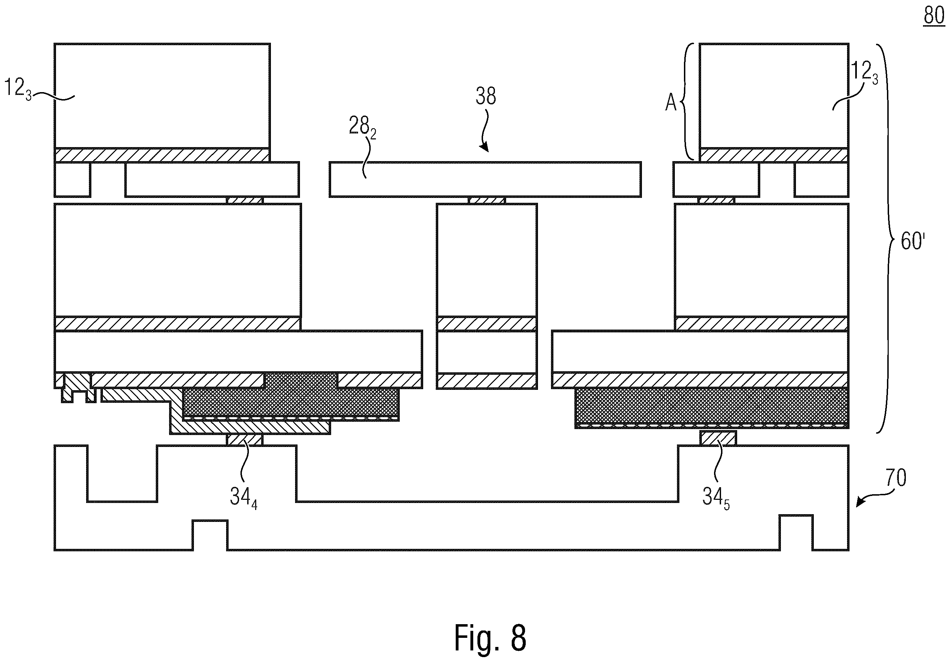

Fig. 8 zeigt eine schematische Seitenschnittansicht einer Stapelstruktur 80 gemäß einem Ausführungsbeispiel, die aus einer bearbeiteten Version 60' der Stapelstruktur 60 aus Fig. 6 und der Waferstruktur 70 aus Fig. 7 erhalten werden kann, etwa indem die Stapelstruktur 60' oder 60 vermittels eines Verbindungsbereichs 34₄ und/oder 34₅ miteinander verbunden wird, etwa durch einen Waferbondingprozess. Beispielsweise können die Bereiche 34₄ und 34₅ einen umlaufenden Bereich bilden, so dass zwischen der Stapelstruktur 60 bzw. 60' und der Waferstruktur 70 eine hermetisch dichte Verbindung erfolgt. Dieser Waferbondingprozess kann in derselben Prozessumgebung oder derselben Prozesskammer erfolgen, wie beispielsweise die Verbindung der Waferstrukturen 40 und 50.

Die Stapelstruktur 60' kann gegenüber der Stapelstruktur 60 weiterbearbeitet sein. Während beispielsweise durch Verbinden der Waferstrukturen 40 und 50, beispielsweise unter Ausführen des Schritts 320, die Segmente "Spiegelelement" und "bewegter Pfosten" aneinandergefügt werden, kann ein bewegliches Element 38 der Stapelstruktur 80 durch ein lokal selektives Entfernen der Substratschicht 12₃ freigelegt werden, etwa gegenüberliegend des Bereichs 28₂. In äußeren Bereichen kann die Substratschicht 12₃ verbleiben und beispielsweise als Abstandsschicht fungieren, um einen Abstand A zu dem beweglichen Element 38 einzustellen, insbesondere für weitere, zusätzliche Schichten. Die Schicht 12₃ kann damit als Abstandsstruktur einen Abstand A zwischen der MEMS-Struktur oder Komponenten hiervon und einer späteren Deckelschicht einstellen und zumindest teilweise bereitstellen. Der Abstand A kann dabei an ein beabsichtigtes Volumen einer späteren Kavität und/oder an einer Bewegungsamplitude beweglicher Komponenten der MEMS-Struktur angepasst sein.

In anderen Worten wird gemäß der Fig. 8 gegenüber den Fig. 6 und 7 der Stapel der funktionalen Wafer wieder mit dem Bodenwafer zusammengebondet. Dabei ist es möglich, durch den funktionalen Wafer einen gewissen Abstand nach oben zum späteren Deckelwafer zu erhalten oder beizubehalten.

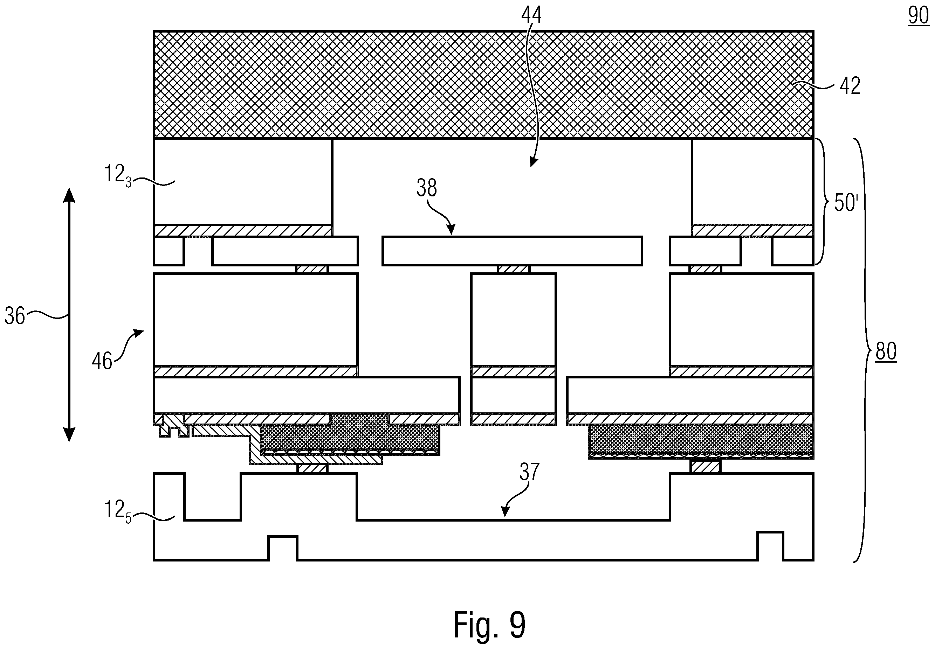

Fig. 9 zeigt eine schematische Seitenschnittansicht einer Stapelstruktur 90 gemäß einem Ausführungsbeispiel, die durch Kombination der Stapelstruktur 80 aus Fig. 8 mit einem Glaswafer 42 erhalten werden kann. Dieser kann beispielsweise als Deckel oder zumindest als Teil hiervon an der Stapelstruktur 80 angeordnet werden, so dass eine Kavität 44, in der das bewegliche Element 38 beweglich angeordnet ist, hermetisch dicht abgeschlossen ist und zwar einerseits durch die Substratschichten 12₅ bzw. dem Bodenwafer und andererseits durch den Glaswafer 42. Der Glaswafer 42 kann ebenfalls vermittels eines Bondingprozesses an der Stapelstruktur 80 angeordnet werden. Hierdurch kann beispielsweise erreicht werden, dass die Prozesskammer für ein lokal selektives Ätzen und/oder für Waferbonden für die Verkapselung des beweglichen Elements 38 nicht verlassen werden muss oder zumindest die Reinraumumgebung beibehalten werden kann, ohne dass hierfür gesteigerte Aufwände erforderlich sind.

Es wird darauf hingewiesen, dass wie auch bei anderen Schritten hierin beschriebener Verfahren, die dargestellte Reihenfolge lediglich exemplarisch ist, aber auch abgeändert werden kann. So kann bspw. die Waferstruktur 70 auch vor einer Verbindung der Strukturen 40 und 50 mit der Waferstruktur 40 verbunden werden; und/oder der Glaswafer kann mit der Waferstruktur 50 verbunden werden, vor oder nachdem die Waferstruktur 70 angeordnet wird und/oder ggf. gar vor einer Verbindung der Waferstrukturen 40 und 50. Insbesondere bei einer anderen Gestaltung der Waferstrukturen oder MEMS kann eine andere Reihenfolge der Bondingschritte vorteilhaft sein, was die Verwendung einer Abstandsstruktur und einer Glasschicht aber nicht beeinträchtigt.

Die dargestellte Reihenfolge des Verbindens von Schichten oder Schichtfolgen ist dabei rein exemplarisch. Es ist beispielsweise ebenfalls möglich, den Glaswafer 42 bereits vor einem Bonden der Waferstruktur 50 oder einer bearbeiteten Version 50' hiervon, in der beispielsweise die Schicht 12₃ lokal selektiv entfernt ist, zu verbinden.

Die Kavität 44 kann in der dargestellten aber auch in anderen Schrittreihenfolgen hermetisch verschlossen werden, indem das Anordnen der funktionalen Waferstruktur 50 bzw. 50' und des Glaswafers 44 in der Stapelstruktur unter Anwendung eines Waferbondingprozesses ausgeführt wird. An einer zum Glaswafer 42 gegenüberliegenden Seite der MEMS-Struktur 46, die beispielsweise das bewegliche Element 38 aufweist, kann vermittels eines weiteren Waferbondingprozesses zuvor oder nach dem Waferbonding zum Verbinden des Glaswafers eine Begrenzungswaferstruktur, die Schicht 12₅, einen Teil der Stapelstruktur bilden, so dass der Glaswafer 42 einerseits und die Begrenzungswaferstruktur 12₅ andererseits die Kavität 44 entlang der Stapelrichtung 36 verschließen. Die funktionale Waferstruktur 40/50 und die Abstandsschicht 12₃ können die Kavität 44 senkrecht zu der Stapelrichtung 36 verschließen.

Wie es im Zusammenhang mit der Fig. 7 beschrieben ist, kann die Begrenzungswaferstruktur 12₅ an eine der MEMS-Struktur 46 zugewandten Seite strukturiert sein, um eine Aussparung in einem der MEMS-Struktur 46 gegenüberliegenden Bereich aufzuweisen. Diese kann beispielsweise an eine Bewegung des beweglichen Elements 38 der MEMS-Struktur 46 angepasst sein.

Dabei kann die Aussparung 37 von einer einzigen oder einzelnen Halbleiterschicht der Begrenzungswaferstruktur 70 begrenzt sein. Das bedeutet, die Aussparung 37 wird beispielsweise durch ein lokal selektives Ätzverfahren oder dergleichen innerhalb einer einzelnen Schicht hergestellt, was sich von einem mehrschichtigen Aufbau unterscheidet, wo beispielsweise Wandstrukturen durch zusätzliche Schichten erzeugt werden. Die Implementierung als eine einzige Schicht mit einer Aussparung bietet den Vorteil einer einfachen und präzisen Definition der Kavität 44.

Der Glaswafer 42 kann ganz oder zumindest in einem Bereich, der der MEMS-Struktur 46 bzw. dem beweglichen Element 38 gegenüberliegend angeordnet ist, planar ausgebildet sein. Der Abstand kann ungeachtet dessen vermittels der Abstandsstruktur 12₃ bereitgestellt werden. Hierdurch kann eine komplexe Herstellung eines dreidimensionalen Glaskörpers als Glaskappe oder CAP vermieden werden und dennoch die Vorteile der Verwendung von Glasmaterial genutzt werden.

Gemäß einem Ausführungsbeispiel wird das Verfahren so ausgeführt, dass die Kavität 44 hermetisch verschlossen wird und in der Kavität ein von einem Atmosphärendruck oder Umgebungsdruck verschiedener Druck vorgesehen wird. Dies kann in Prozesskammern zum Waferbonden anders als auf Labortischen zum klassischen Verkleben mehrerer Schichten einfach erfolgen. Ausführungsbeispiele sehen vor, dass ein Unterdruck in der Kavität erzeugt wird. Andere Ausführungsbeispiele sehen vor, dass ein Überdruck in der Kavität erzeugt wird, beispielsweise ein Druck von zumindest 1,5 bar, 1,8 bar oder zumindest 2 bar oder auch höhere Drücke, beispielsweise 3 bar. Ein Überdruck ermöglicht es, eine Bewegung des beweglichen Elements 38 abzubremsen. Dies ist insbesondere von Relevanz bei Strukturen, die nicht-resonant angetrieben werden und ermöglicht es beispielsweise ein Überschwingen über eine angestrebte Position hinaus zu reduzieren oder zu vermeiden.

Durch das Einstellen des Drucks während der Aneinanderfügung von Schichten ist es ebenfalls möglich, dass in einem Bereich der Kavität kein Gettermaterial angeordnet wird. Ein solches Gettermaterial wird in bekannte Prozessen angeordnet, um eine Druckanpassung zu ermöglichen, etwa um einen Unterdruck später zu erzeugen. Da dies nun bereits während des Waferbondings erfolgen kann, ist eine Anordnung eines solchen Materials weiterhin möglich, der Bedarf hierfür ist aber reduziert oder gar vermieden.

In der Stapelstruktur 90 ist ein bewegliches Element 38 angeordnet. Ferner ist ein Aktuator vorgesehen, um das bewegliche Element 38 aus einer Ruhelage, die beispielsweise durch Federelemente oder dergleichen mitbeeinflusst ist, auszulenken. Beispielsweise umfasst das bewegliche Element 38 eine Spiegelstruktur.

Die MEMS-Struktur kann dabei so ausgestaltet sein, dass eine Ansteuerung des beweglichen Elements 38 unterhalb einer mechanischen Resonanzfrequenz eines Feder-Masse-Systems erfolgt. Das bewegliche Element 38 kann Teil einer Masse eines solchen FederMasse-Systems bereitstellen. Eine Federaufhängung kann dabei einen Feder-Teil bereitstellen, was beides zusammengenommen eine Resonanzfrequenz beeinflusst. Während bei resonanzbetriebenen Spiegeln beispielsweise die Federn weich aufgehängt sind, um den resonanten Betrieb zu ermöglichen, ist bei Strukturen für einen nicht-resonanten Betrieb eine wesentlich höhere Federsteifigkeit vorgesehen.

Wie es beispielsweise im Zusammenhang mit der Fig. 8 dargestellt ist und im Zusammenhang mit der Fig. 9 weiter verdeutlicht ist, kann vermittels des lokal selektiven Entfernens, etwa durch Ausführen des Schritts 330, um einen Teil der Abstandsschicht 12₃ nach einem erfolgten Waferbondingprozess zu entfernen, gleichzeitig genutzt werden, um ein entsprechendes Segment der MEMS-Struktur 46 freizulegen, und um so eine spätere Bewegung des beweglichen Elements 38 zu ermöglichen. Dies kann unter Beibehaltung zumindest eines Teils der Abstandsschicht 12₃ in dem beispielsweise äußeren Bereich der Kavität 44 erfolgen, so dass der Bereich, aus dem die Schicht 12₃ entfernt wird von dem verbleibenden Anteil umschlossen ist und die Abstandsstruktur zumindest teilweise bildet. Dies schließt nicht aus, dass die Schicht 12₃ lokal auch in einem äußeren Bereich zum Einstellen des Abstands abgedünnt wird oder weiter strukturiert wird.

In anderen Worten zeigt Fig. 9 eine schematische Darstellung zum dritten Waferbonding, zu dem ein Deckelwafer mit dem bisherigen Waferstapel zusammengebaut wird, so dass in der Mitte eine hermetisch verkapselte Kavität 44 entsteht. Innerhalb dieser Kavität ist es auch möglich, einen definierten Druck und/oder eine definierte Atmosphärenzusammensetzung einzustellen, so dass sowohl Unterdruck (technisches Vakuum), Atmosphäre als auch Überdruck als Arbeitsumgebung für die MEMS-Komponente ermöglicht sind. Ein Überdruck kann zur Dämpfung einer Nachschwingung einer Bewegung der MEMS-Komponente eingesetzt werden.

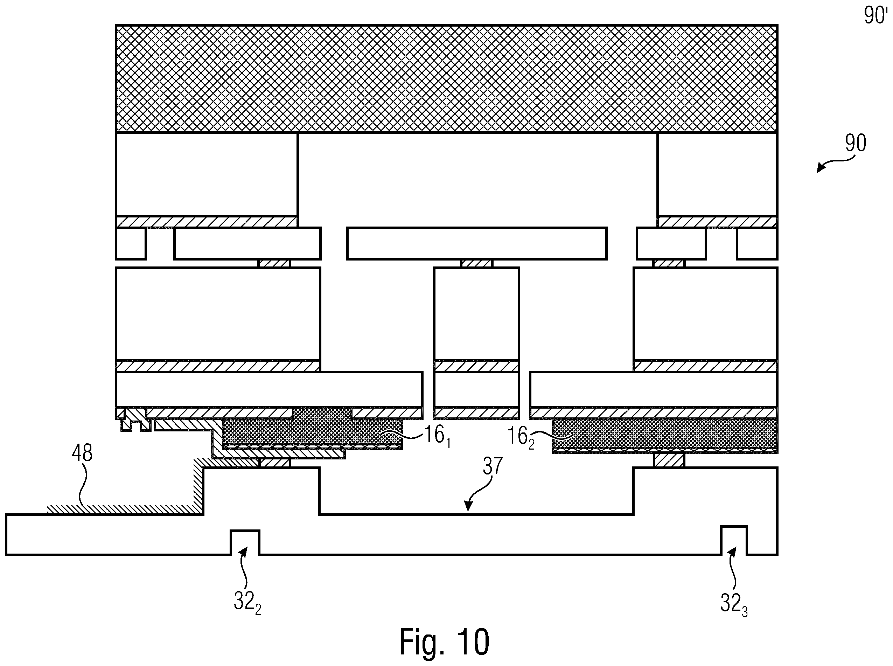

Fig. 10 zeigt eine schematische Seitenschnittansicht einer Stapelstruktur 90' gemäß einem Ausführungsbeispiel, die durch weitere Bearbeitung der Stapelstruktur 90 aus Fig. 9 erhalten werden kann. So kann beispielsweise eine zusätzliche Metallisierung 48 vorgesehen sein, um die Aktuatorstrukturen 16₁ und/oder 16₂ elektrisch zu kontaktieren.

Derartige Schritte sind optional. Gemäß einem Ausführungsbeispiel umfasst ein erfindungsgemäßes Verfahren ein Vereinzeln der Stapelstruktur in eine Vielzahl von MEMS-Packages, etwa in einen Bereich der Gräben 32₂ und/oder 32₃.

Ausführungsbeispiele sind darauf gerichtet, die Abstandsschicht 12₃ aus einem Halbleitermaterial bereitzustellen, wobei dies nicht zwingend erforderlich ist, selbst wenn dadurch gewisse Vorteile erhalten werden, insbesondere im Hinblick auf die MEMS-Fertigung.

In anderen Worten kann optional ein Bodenwafer metallisiert werden, um einen elektrischen Kontakt zu der MEMS-Komponente zu realisieren. Der Glas-Frit, das bedeutet, die Schnittstelle zwischen der Abstandsstruktur 12₃ und dem Glaswafer 42 kann elektrisch leitfähig sein, um alternativ oder zusätzlich einen elektrischen Kontakt zu der MEMS-Komponente zu realisieren.

Gemäß einem Ausführungsbeispiel umfasst ein Verfahren ein Bearbeiten der funktionalen Waferstruktur 40 und/oder 50 in einer Prozesskammer und ein Verschließen der Kavität in der Prozesskammer. Ausführungsbeispiele ermöglichen eine unterschiedliche Reihenfolge von Bondingvorgängen, zum Teil auch simultan, wobei sequentielle Bondingvorgänge in derselben oder einer anderen Prozesskammer ausgeführt werden können. So kann bspw. die Waferstruktur 40 aus Fig. 4 und die Waferstruktur 50 aus Fig. 5 sowie die Struktur 70 aus Fig. 7 vorbereitet und möglicherweise fertig strukturiert sein und die drei Wafer können gleichzeitig, in einem Schritt zusammen gebondet werden, was eine schnelle Prozessführung ermöglicht.

Allerdings kann es einfacher sein, die Waferstrukturen 40 und 50 zuerst zusammen zu bonden, dann die Spiegelplatte zu ätzen bzw. freizulegen und dann anschließend mit der Waferstruktur 70 noch zusammen zu bonden. Gemäß einem Ausführungsbeispiel, das alternativ oder zusätzlich zu dem Verfahren 100 ausgeführt werden kann, erfolgt zum Verkapseln einer MEMS-Struktur in einer Stapelstruktur ein Bereitstellen einer Stapelstruktur mit einer Vielzahl von MEMS-Bereichen, so dass jeder MEMS-Bereich eine MEMS-Struktur aufweist, die zumindest teilweise in einer MEMS-Kavität angeordnet ist, so dass die Stapelstruktur eine Abstandsstruktur aufweist, die jede der Kavitäten der MEMS-Bereiche zumindest teilweise umschließt und einen Abstand zu der MEMS-Struktur bereitstellt. Ferner erfolgt eine Anordnung eines Glaswafers, etwa des Wafers 42, an der Abstandsstruktur durch Ausführen eines Waferbondingprozesses, so dass vermittels des Glaswafers die Kavitäten an einer Seite der Abstandsstruktur hermetisch dicht verschlossen werden. So kann beispielsweise eine Waferstruktur mit mehreren, das heißt, ein Mehrfachnutzen bzw. auf Waferebene bereitgestellten Schichtstapeln 80 angeordnet werden und gleichzeitig vermittels Waferbonding durch den Glaswafer 42 zumindest an einer Seite verschlossen werden.

Obwohl das hierin beschriebene Verfahren so beschrieben ist, dass die Waferstruktur 70 verwendet wird, um eine dem Glaswafer 42 gegenüberliegende Seite zu verschließen, ist dies nicht in allen Ausführungsbeispielen vorgesehen. So kann beispielsweise eine durchgehende Substratschicht genutzt werden, die Teil der Waferstruktur 40 ist und bereits eine Versiegelung der Kavität an dieser Seite vorsieht. Alternativ oder zusätzlich ist es möglich, die Versiegelung der Kavität an dieser Seite wegzulassen oder zu einem späteren Zeitpunkt auszuführen.

Ein MEMS-Package gemäß einem Ausführungsbeispiel, das beispielsweise durch Vereinzelung der Stapelstruktur 90 oder 90` erhalten werden kann, aber auch eine beliebige andere MEMS-Struktur aufweisen kann, umfasst eine Stapelstruktur, die mehrere entlang der Stapelrichtung 36 gestapelte Schichten umfasst, und eine funktionale Schichtstruktur aufweist, die eine MEMS-Struktur umfasst, beispielsweise die MEMS-Struktur 46. Die MEMS-Struktur ist dabei zumindest teilweise in einer Kavität angeordnet, etwa die Kavität 44, die das bewegliche Element 38 aufweist. Die Kavität ist entlang der Stapelrichtung an einer Seite von einer Glasschicht begrenzt, welche durch eine Abstandsschicht entlang einer Stapelrichtung von der MEMS-Struktur beabstandet ist.

Ausführungsbeispiele stellen eine hermetisch Verkapselung auf Waferlevel bereit, die insbesondere aber nicht ausschließlich für quasi-statische MEMS-Komponenten, wie beispielsweise MEMS-Vektor-Scanner, wo jegliches Resonanzverhalten zu vermeiden ist, vorteilhaft sind. Eine Waferlevel-hermetische Verkapselung schützt nicht nur die MEMS-Komponenten vor Umwelteinflüssen wie Staub, Feuchtigkeit, Vibration und dergleichen von der Umgebung, es erlaubt auch einen definierten Innendruck innerhalb der Verkapselung, so dass die Verhaltensweisen der MEMS-Komponenten unabhängig vom Umgebungsdruck sein können.

Für die Umsetzung der hermetischen Verkapselung durch ein Waferbonding werden in Ausführungsbeispielen drei bis vier Wafer bzw. Waferstrukturen eingesetzt. Diese sind im Zusammenhang mit den hierin beschriebenen Figuren erläutert. In den Ausführungen wird beispielhaft ein MEMS-Vektor-Scanner verkapselt, wobei das Prinzip auch auf andere MEMS übertragbar ist.

Ausführungsbeispiele können dabei unabhängig von Strukturen, Größen und Antriebsprinzipien realisiert werden. MEMS-Komponenten können durch die beschriebenen Verfahren auf Wafer-Level hermetisch eingekapselt werden, um diese MEMS-Komponente vor der Umgebung zu schützen, wobei die Ausführungsbeispiele insbesondere vorteilhaft sind bei der Verwendung von ein bis zwei funktionalen Waferstrukturen. In der Kavität kann nicht nur Unterdruck (technisches Vakuum, also bis hin zu technisch realisierbaren Niederdrücken), sondern auch Überdruck eingestellt werden. Mit Überdruck kann der Q-Faktor, das heißt, die Dämpfung, der Bewegung der MEMS-Komponenten gesenkt werden, so dass die Nachschwingung deutlich gedämpft oder eliminiert werden kann.

Ausführungsbeispiele können bei der Herstellung von MEMS-Komponenten, wie beispielsweise einem Vektor-Scanner angewendet werden.

Ausführungsbeispiele beziehen sich dabei auf einen Waferstapel, in dem drei bis vier Wafer zusammengebondet werden sein können und der eine funktionale MEMS-Komponente sowie einen Bodenwafer und einen Deckelwafer aufweist, so dass die mittig angeordnete MEMS-Komponente in einer geschlossenen Kavität unter einem definierten Druck arbeiten kann.

Gemäß einem Ausführungsbeispiel können aus der Schutzfunktion Vakuum, Atmosphäre, aber auch Überdruck als Arbeitsdruck für die Komponente in der Kavität eingestellt werden, um die Gütefaktoren zu erhöhen oder zu senken.

Der Bodenwafer kann gemäß einem Ausführungsbeispiel metallisiert werden, um den elektrischen Kontakt zu der MEMS-Komponente zu realisieren.

Gemäß einem alternativen oder zusätzlichen Aspekt kann der Glas-Frit elektrisch leitfähig sein, um den elektrischen Kontakt zu der MEMS-Komponente zu realisieren.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literatur

[1] "Variants of Hermetic Packages for LiDAR Sensors | SCHOTT". /engb/products/hermetic-packages-for-lidar-sensors/product-variants (zugegriffen Sep. 21, 2020).
[2] "Mirrorcle Technologies MEMS Mirrors - Technical Overview", 2013. https://www.semanticscholar.org/paper/Mirrorcle-Technologies-MEMS-Mirrors-%E2%80%93- Technical/d131 a1576787ffa47fbd035881 ec3780cf1 a09b4 (zugegriffen Sep. 21, 2020).
[3] S. Gu-Stoppel *u.* a., "AlScN based MEMS quasi-static mirror matrix with large tilting angle and high linearity", Sens. Actuators Phys., Bd. 312, S. 112107, Sep. 2020, doi: 10.1016/j.sna.2020.112107.

## Patentansprüche

1. Verfahren zum Verkapseln einer MEMS-Struktur in einer Stapelstruktur, die mehrere entlang einer Stapelrichtung gestapelte Schichten umfasst, mit folgenden Schritten:
Bereitstellen (110) einer funktionalen Waferstruktur, die zumindest teilweise die MEMS-Struktur umfasst;
Anordnen (120) der funktionalen Waferstruktur und eines Glaswafers (42) in der Stapelstruktur und entlang einer Stapelrichtung (36) zueinander;
so dass eine Kavität (44), in welcher zumindest ein Teil der MEMS-Struktur angeordnet ist, an einer Seite entlang der Stapelrichtung (36) mit dem Glaswafer (42) verschlossen ist; und
so dass eine Abstandsstruktur (12₃) zwischen dem Teil der MEMS-Struktur und dem Glaswafer (42) in der Stapelstruktur angeordnet wird, um einen Abstand (A) zwischen dem Teil der MEMS-Struktur und dem Glaswafer (42) entlang der Stapelrichtung (36) bereitzustellen; so dass die Abstandsstruktur (12₃) einen Teil der Kavität (44) umschließt, **dadurch gekennzeichnet, dass**
die Abstandsstruktur (12₃) aus der funktionalen Waferstruktur mittels lokal selektiver Entfernung der Waferstruktur gebildet wird.

2. Verfahren gemäß Anspruch 1, bei dem das Bereitstellen der funktionalen Waferstruktur ein Bereitstellen eines ersten funktionalen Wafers (40) mit einem mechanischen Element und eines zweiten funktionalen Wafers (50) umfasst und das Verfahren ein Waferbonden des ersten funktionalen Wafers und des zweiten funktionalen Wafers mit einander vermittels eines Waferbondingprozesses umfasst.

3. Verfahren gemäß einem der vorangehenden Ansprüche, bei dem die Kavität (44) hermetisch verschlossen wird, indem das Anordnen der funktionalen Waferstruktur und des Glaswafer (42) in der Stapelstruktur unter Anwendung eines ersten Waferbondingprozesses ausgeführt wird; und indem an einer zum Glaswafer (42) gegenüberliegenden Seite der MEMS-Struktur vermittels eines zweiten Waferbondingprozesses eine Begrenzungswaferstruktur einen Teil der Stapelstruktur bildet, so dass der Glaswafer (42) einerseits und die Begrenzungswaferstruktur andererseits die Kavität (44) entlang der Stapelrichtung (36) verschließen; und die funktionale Waferstruktur und die Abstandsstruktur die Kavität (44) senkrecht hierzu begrenzen.

4. Verfahren gemäß Anspruch 3, bei dem die Begrenzungswaferstruktur an einer der MEMS-Struktur zugewandten Seite strukturiert ist, und eine Aussparung (37) in einem der MEMS-Struktur gegenüberliegenden Bereich aufweist.

5. Verfahren gemäß einem der vorangehenden Ansprüche, bei dem der Glaswafer (42) zumindest in einem Bereich, der der MEMS-Struktur gegenüberliegend angeordnet ist, planar ausgebildet ist.

6. Verfahren gemäß einem der vorangehenden Ansprüche, bei dem eine der MEMS-Struktur zugewandte Seite des Glaswafers (42) planar ausgebildet ist.

7. Verfahren gemäß einem der vorangehenden Ansprüche, das so ausgeführt wird, dass die Kavität (44) hermetisch verschlossen wird und in der Kavität (44) ein von einem Atmosphärendruck verschiedener Druck vorgesehen wird.

8. Verfahren gemäß Anspruch 7, bei dem ein Unterdruck in der Kavität (44) erzeugt wird; oder
bei dem ein Überdruck in der Kavität (44) erzeugt wird.

9. Verfahren gemäß Anspruch 7 oder 8, bei dem kein Gettermaterial in einem Bereich der Kavität (44) angeordnet wird.

10. Verfahren gemäß einem der vorangehenden Ansprüche, bei dem die MEMS-Struktur ein bewegliches Element (38) und einen Aktuator (16₁, 16₂) zum Auslenken des beweglichen Elements (38) aus einer Ruhelage umfasst.

11. Verfahren gemäß einem der vorangehenden Ansprüche, ferner umfassend:
Lokal selektives Entfernen (330) einer Abstandsschicht nach dem Waferbondingprozess in einem ersten Bereich, um das funktionalen Waferstruktur zumindest teilweise freizulegen, unter Beibehaltung zumindest eines Teils der Abstandsschicht in einem zweiten Bereich, der den ersten Bereich umschließt, um die Abstandsstruktur (12₃) zumindest teilweise zu bilden.

12. Verfahren gemäß einem der vorangehenden Ansprüche, bei dem das Bereitstellen der funktionalen Waferstruktur Folgendes umfasst:
ein Bereitstellen (310) eines ersten funktionalen Wafers der ein erstes Segment eines beweglichen Elements der MEMS-Struktur umfasst; und eines zweiten funktionalen Wafers der ein zweites Segment des beweglichen Elements der MEMS-Struktur und zumindest eine Abstandsschicht umfasst, die mit dem zweiten Segment einen Stapel zumindest teilweise bildet;
ein Waferbonden (320) des ersten funktionalen Wafers und des zweiten funktionalen Wafers mit einander vermittels eines Waferbondingprozesses; so dass das erste Segment und das zweite Segment mit einander verbunden werden, um das bewegliche Element zumindest teilweise zu bilden;
wobei das Verfahren ferner umfasst:
Lokal selektives Entfernen (330) der Abstandsschicht nach dem Waferbondingprozess in einem ersten Bereich des zweiten Segments, um das zweite Segment freizulegen, unter Beibehaltung zumindest eines Teils der Abstandsschicht in einem zweiten Bereich, der den ersten Bereich umschließt, um die Abstandsstruktur (12₃) zumindest teilweise zu bilden.

13. Verfahren gemäß einem der vorangehenden Ansprüche, ferner umfassend:
Bearbeiten der funktionalen Waferstruktur in einer Prozesskammer; und
Verschließen der Kavität (44) in derselben Prozesskammer oder einer anderen Prozesskammer.

14. Verfahren zum Verkapseln von MEMS Strukturen in einer Stapelstruktur mit folgenden Schritten:
Bereitstellen einer Stapelstruktur, die mehrere entlang einer Stapelrichtung gestapelte Schichten umfasst, mit einer funktionalen Waferstruktur mit einer Vielzahl von MEMS-Bereichen, so dass
jeder MEMS-Bereich eine MEMS-Struktur aufweist, die zumindest teilweise in einer MEMS-Kavität (44) angeordnet ist; so dass die Stapelstruktur eine Abstandsstruktur (12₃) aufweist, die jede der Kavitäten der MEMS-Bereiche zumindest teilweise umschließt und entlang der Stapelrichtung (36) einen Abstand (A) zu der MEMS-Struktur bereitstellt, und
Anordnen eines Glaswafers (42) an der Abstandsstruktur (12₃) entlang der Stapelrichtung (36) durch Ausführen eines Waferbondingprozesses, so dass vermittels des Glaswafers (42) die Kavitäten an einer Seite der Abstandsstruktur (12₃) hermetisch dicht verschlossen werden, **dadurch gekennzeichnet, dass** die Abstandsstruktur (12₃) aus der funktionalen Waferstruktur mittels lokal selektiver Entfernung der funktionalen Waferstruktur gebildet ist.

15. MEMS-Package mit:
einer Stapelstruktur, die mehrere entlang einer Stapelrichtung (36) gestapelte Schichten umfasst; und die eine funktionale Waferstruktur aufweist, die eine MEMS-Struktur umfasst;
wobei die MEMS-Struktur zumindest teilweise in einer Kavität (44) angeordnet ist;
und die Kavität (44) einen Teil der Stapelstruktur bildet;
wobei die Kavität (44) entlang der Stapelrichtung (36) an einer Seite von einer Glasschicht begrenzt ist, die durch eine Abstandsstruktur (12₃) entlang der Stapelrichtung (36) von der MEMS-Struktur beabstandet ist, **dadurch gekennzeichnet, dass** die Abstandsstruktur (12₃) aus der funktionalen Waferstruktur mittels lokal selektiver Entfernung der Waferstruktur gebildet ist.

## Claims

1. Method for encapsulating an MEMS structure in a stack structure including several layers stacked along a stacking direction, comprising:
providing (110) a functional wafer structure including at least partly the MEMS structure;
arranging (120) the functional wafer structure and a glass wafer (42) in the stack structure and along a stacking direction (36) to each other;
such that a cavity (44) in which at least a part of the MEMS structure is arranged is closed on one side along the stacking direction (36) by the glass wafer (42); and
such that a spacing structure (12₃) is arranged between the part of the MEMS structure and the glass wafer (42) in the stack structure to provide a spacing (A) between the part of the MEMS structure and the glass wafer (42) along the stacking direction (36); such that the spacing structure (12₃) encloses part of the cavity (44), **characterized in that**
the spacing structure (12₃) is formed of the functional wafer structure by means of local selective removal of the wafer structure.

2. Method according to claim 1, wherein providing the functional wafer structure includes providing a first functional wafer (40) with a mechanical element and a second functional wafer (50) and the method includes wafer bonding the first functional wafer and the second functional wafer with one another by means of a wafer bonding process.

3. Method according to any of the preceding claims, wherein the cavity (44) is hermetically closed by arranging the functional wafer structure and the glass wafer (42) in the stack structure by using a first wafer bonding process; and by a limiting wafer structure forming part of the stack structure on a side of the MEMS structure opposite to the glass wafer (42) by means of a second wafer bonding process, such that the glass wafer (42) on the one hand and the limiting wafer structure on the other hand close the cavity (44) along the stacking direction (36); and the functional wafer structure and the spacing structure limit the cavity (44) perpendicular thereto.

4. Method according to claim 3, wherein the limiting wafer structure is structured on a side facing the MEMS structure and comprises a recess (37) in an area opposite to the MEMS structure.

5. Method according to any of the preceding claims, wherein the glass wafer (42) is formed in a planner manner at least in an area that is arranged opposite to the MEMS structure.

6. Method according to any of the preceding claims, wherein a side of the glass wafer (42) facing the MEMS structure is formed in a planar manner.

7. Method according to any of the preceding claims, which is performed such that the cavity (44) is hermetically closed and a pressure differing from the atmosphere pressure is provided in the cavity (44).

8. Method according to claim 7, wherein a negative pressure is generated in the cavity (44); or
wherein an overpressure is generated in the cavity (44).

9. Method according to claim 7 or 8, wherein no getter material is arranged in an area of the cavity (44).

10. Method according to any of the preceding claims, wherein the MEMS structure includes a moveable element (38) and an actuator (16₁, 16₂) for deflecting the moveable element (38) from a resting position.

11. Method according to any of the preceding claims, further comprising:
locally selectively removing (330) a spacing layer after the wafer bonding process in a first area to expose the functional wafer structure at least partly while maintaining at least a part of the spacing layer in a second area enclosing the first area to at least partly form the spacing structure (12₃).

12. Method according to any of the preceding claims, wherein providing the functional wafer structure includes:
providing (310) a first functional wafer including a first segment of a moveable element of the MEMS structure; and a second functional wafer including a second segment of the moveable element of the MEMS structure and at least a spacing layer that at least partly forms a stack together with the second segment;
wafer bonding (320) of the first functional wafer and the second functional wafer with one another by means of a wafer bonding process; such that the first segment and the second segment are connected to one another, to at least partly form the moveable element;
wherein the method further comprises:
locally selectively removing (330) the spacing layer after the wafer bonding process in a first area of the second segment to expose the second segment while maintaining at least of the spacing layer in a second area enclosing the first area to at least partly form the spacing structure (12₃).

13. Method according to any of the preceding claims, further comprising:
processing the functional wafer structure in a process chamber;
closing the cavity (44) in the same process chamber or a different process chamber.

14. Method for encapsulating MEMS structures in a stack structure, comprising:
providing a stack structure including several layers stacked along a stacking direction with a functional wafer structure with a plurality of MEMS areas, such that each MEMS area comprises an MEMS structure that is arranged at least partly in an MEMS cavity (44); such that the stack structure comprises a spacing structure (12₃) enclosing each of the cavities of the MEMS areas at least partly and providing a spacing (A) to the MEMS structure along the stacking direction (36); and
arranging a glass wafer (42) on the spacing structure (12₃) along the stacking direction (36) by performing a wafer bonding process, such that the cavities on one side of the spacing structure (12₃) are hermetically sealed by means of the glass wafer (42), **characterized in that** the spacing structure (12₃) is formed from the functional wafer structure by means of local selective removal of the functional wafer structure.

15. MEMS package, comprising:
a stack structure including several layers stacked along a stacking direction (36); and comprising a functional wafer structure including an MEMS structure;
wherein the MEMS structure is at least partly arranged in a cavity (44); and the cavity (44) forms part of the stack structure;
wherein the cavity (44) is limited on one side along the stacking direction (36) by a glass layer, which is spaced apart from the MEMS structure along the stacking direction (36) by a spacing structure (12₃), **characterized in that** the spacing structure (12₃) is formed from the functional wafer structure by means of local selective removal of the wafer structure.

## Revendications

1. Procédé d'encapsulation d'une structure MEMS dans une structure à empilement qui comporte plusieurs couches empilées le long d'une direction d'empilement, aux étapes suivantes consistant à:
prévoir (110) une structure de plaquettes fonctionnelle qui comporte au moins partiellement la structure MEMS;
disposer (120) la structure de plaquettes fonctionnelle et une plaquette de verre (42) l'une par rapport à l'autre dans la structure à empilement et le long d'une direction d'empilement (36);
de sorte qu'une cavité (44), dans laquelle est disposée au moins une partie de la structure MEMS, soit fermée d'un côté le long de la direction d'empilement (36) par la plaquette de verre (42); et
de sorte qu'une structure d'espacement (12₃) soit disposée entre la partie de la structure MEMS et la plaquette de verre (42) dans la structure d'empilement pour créer une distance (A) entre la partie de la structure MEMS et la plaquette de verre (42) le long de la direction d'empilement (36); de sorte que la structure d'espacement (12₃) entoure une partie de la cavité (44),
**caractérisé par le fait que**
la structure d'espacement (12₃) est formée à partir de la structure de plaquettes fonctionnelle au moyen d'une élimination sélective localement de la structure de plaquettes.

2. Procédé selon la revendication 1, dans lequel la prévision de la structure de plaquettes fonctionnelle comporte le fait de prévoir une première plaquette fonctionnelle (40) avec un élément mécanique et une deuxième plaquette fonctionnelle (50), et le procédé comporte le fait d'assembler la première plaquette fonctionnelle et la deuxième plaquette fonctionnelle l'une à l'autre au moyen d'un processus d'assemblage de plaquettes.

3. Procédé selon l'une quelconque des revendications précédentes, dans lequel la cavité (44) est hermétiquement fermée en réalisant la disposition de la structure de plaquettes fonctionnelle et de la plaquette de verre (42) dans la structure à empilement à l'aide d'un premier processus d'assemblage de plaquettes; et en ce que d'un côté de la structure MEMS opposé à la plaquette de verre (42) une structure de plaquettes de limitation forme, au moyen d'un deuxième processus d'assemblage de plaquettes, une partie de la structure à empilement, de sorte que la plaquette de verre (42), d'une part, et la structure de plaquettes de limitation, d'autre part, ferment la cavité (44) le long de la direction d'empilement (36); et que la structure de plaquettes fonctionnelle et la structure d'espacement limitent la cavité (44) de manière perpendiculaire à cette dernière.

4. Procédé selon la revendication 3, dans lequel la structure de plaquettes de limitation est structurée d'un côté orienté vers la structure MEMS et présente un évidement (37) dans une zone opposée à la structure MEMS.

5. Procédé selon l'une des revendications précédentes, dans lequel la plaquette de verre (42) est réalisée plane au moins dans une zone qui est disposée opposée à la structure MEMS.

6. Procédé selon l'une des revendications précédentes, dans lequel une face de la plaquette de verre (42) tournée vers la structure MEMS est conçue de manière à être plane.

7. Procédé selon l'une des revendications précédentes, qui est réalisé de sorte que la cavité (44) soit fermée hermétiquement et que dans la cavité (44) soit prévue une pression différente d'une pression atmosphérique.

8. Procédé selon la revendication 7, dans lequel une pression négative est générée dans la cavité (44); ou
dans lequel une surpression est générée dans la cavité (44).

9. Procédé selon la revendication 7 ou 8, dans lequel il n'est pas disposé de matériau piégeur dans une zone de la cavité (44).

10. Procédé selon l'une des revendications précédentes, dans lequel la structure MEMS comporte un élément mobile (38) et un actionneur (16₁, 16₂) destiné à dévier l'élément mobile (38) à partir d'une position de repos.

11. Procédé selon l'une quelconque des revendications précédentes, comportant par ailleurs le fait de:
éliminer de manière sélective localement (330) une couche d'espacement après le processus d'assemblage de plaquettes dans une première zone pour exposer au moins partiellement la structure de plaquettes fonctionnelle, tout en maintenant au moins une partie de la couche d'espacement dans une deuxième zone qui entoure la première zone pour former au moins partiellement la structure d'espacement (12₃).

12. Procédé selon l'une quelconque des revendications précédentes, dans lequel la prévision de la structure de plaquettes fonctionnelle comporte le fait de:
prévoir (310) une première plaquette fonctionnelle qui comporte un premier segment d'un élément mobile de la structure MEMS; et une deuxième plaquette fonctionnelle qui comporte un deuxième segment de l'élément mobile de la structure MEMS et au moins une couche d'espacement qui forme, avec le deuxième segment, au moins partiellement un empilement;
assembler (320) la première plaquette fonctionnelle et la deuxième plaquette fonctionnelle l'une à l'autre au moyen d'un processus d'assemblage de plaquettes; de sorte que le premier segment et le deuxième segment soient assemblés l'un à l'autre pour former au moins partiellement l'élément mobile;
dans lequel le procédé comporte par ailleurs le fait de:
éliminer de manière sélective localement (330) la couche d'espacement après le processus d'assemblage de plaquettes dans une première zone du deuxième segment pour exposer le deuxième segment, tout en maintenant au moins une partie de la couche d'espacement dans une deuxième zone qui entoure la première zone, pour former au moins partiellement la structure d'espacement (12₃).

13. Procédé selon l'une quelconque des revendications précédentes, comportant par ailleurs le fait de:
traiter la structure de plaquettes fonctionnelle dans une chambre de traitement; et
fermer la cavité (44) dans la même chambre de traitement ou dans une autre chambre de traitement.

14. Procédé d'encapsulation de structures MEMS dans une structure à empilement aux étapes suivantes consistant à:
prévoir une structure à empilement qui comporte plusieurs couches empilées le long d'une direction d'empilement, avec une structure de plaquettes fonctionnelle avec une pluralité de zones MEMS, de sorte que chaque zone MEMS présente une structure MEMS qui est disposée au moins partiellement dans une cavité MEMS (44), de sorte que la structure à empilement présente une structure d'espacement (12₃) qui entoure au moins partiellement chacune des cavités des zones MEMS et crée, le long de la direction d'empilement (36), une distance (A) par rapport à la structure MEMS; et
disposer une plaquette de verre (42) sur la structure d'espacement (12₃) le long de la direction d'empilement (36) en effectuant un processus d'assemblage de plaquettes, de sorte que, au moyen de la plaquette de verre (42), les cavités d'un côté de la structure d'espacement (12₃) soient fermées de manière hermétique,
**caractérisé par le fait que** la structure d'espacement (12₃) est formée à partir de la structure de plaquettes fonctionnelle au moyen d'une élimination sélective localement de la structure de plaquettes fonctionnelle.

15. Paquet MEMS avec:
une structure d'empilement qui comporte plusieurs couches empilées le long d'une direction d'empilement (36); et qui présente une structure de plaquettes fonctionnelle qui comporte une structure MEMS;
dans lequel la structure MEMS est disposée au moins partiellement dans une cavité (44); et la cavité (44) forme une partie de la structure d'empilement;
dans lequel la cavité (44) est limitée le long de la direction d'empilement (36) d'un côté par une couche de verre qui est distante, par suite d'une structure d'espacement (12₃), le long de la direction d'empilement (36) de la structure MEMS,
**caractérisé par le fait que** la structure d'espacement (12₃) est formée à partir de la structure de plaquettes fonctionnelle au moyen de la élimination sélective localement de la structure de plaquettes.
